# EUROPÄISCHE PATENTSCHRIFT

(11) **EP 0 668 692 B1**
(45) Veröffentlichungstag und Bekanntmachung des Hinweises auf die Patenterteilung: **11.04.2001**
(21) Anmeldenummer: 95101244.2
(22) Anmeldetag: 30.01.1995
(51) Int. Cl.: H04N 5/225

(54) **Gegen elektromagnetische Strahlung geschützte Videokamera**
Video camera protected against electromagnetic radiation
Caméra vidéo protégée contre les radiations électromagnétiques

(30) Priorität: 18.02.1994 DE 9402722 U
(43) Veröffentlichungstag der Anmeldung: 23.08.1995
(73) Patentinhaber: SIEMENS AKTIENGESELLSCHAFT, 80333 München (DE)
(72) Erfinder: Lange, Horst, D-76189 Karlsruhe (DE); Stolberg, Dieter, D-76344 Eggenstein-Leopoldshafen (DE)

(56) Entgegenhaltungen:
- EP-A- 0 280 351
- DE-U- 8 510 660
- DE-U- 9 107 917
- US-A- 4 298 894
- PROTECTOR, Bd. 18,Nr. 1, 1.März 1990 ZÜRICH, CH, Seite 93 XP 000244411 'Kamerasystem'

## Beschreibung

Die Erfindung betrifft eine gegen elektromagnetische Strahlung geschützte Videokamera gemäß dem Oberbegriff des Anspruchs 1.

Videokameras sind gegen elektromagnetische Strahlung sehr empfindlich. Werden sie in einer Umgebung mit starker elektromagnetischer Strahlung eingesetzt, müssen ihre Gehäuse daher so gestaltet sein, daß die empfindlichen elektronischen Bauteile gegen elektromagnetische Strahlung geschützt sind, so wie dies aus Protector, Bd. 18, Nr. 1, 01.03.1990, Zürich, Seite 93, bekannt ist.

Aus der DE-U-85 10 660 ist eine Videokamera mit einem Gehäuse bekannt, das ein rohrförmiges Metallprofil mit im wesentlichen rechteckigem Querschnitt aufweist, dessen Stirnseiten von Kappen verschlossen sind. Die Kappen sind auf den Stirnseiten aufgeschraubt und enthalten jeweils eine Ringnut, in die eine auf der Stirnseite des Metallprofils aufsitzende Dichtung gegen das Eindringen von Wasser gelegt ist.

Aus der EP-A-0 280 351 ist die Verwendung eines Metallgeflechts als elektromagnetische Dichtung bekannt.

Aus der DE-U-91 07 917 ist ein Gehäuse mit einem EMV-dichten Fenster bekannt, bei dem die Fensterscheibe mit einem Abschirmnetz abgedeckt ist und eine elektrisch leitende Dichtung die elektrische Verbindung zwischen dem Abschirmnetz und dem metallischen Gehäuse herstellt.

Der Erfindung liegt die Aufgabe zugrunde, eine gegen elektromagnetische Strahlung geschützte Videokamera mit besonders vorteilhaftem Gehäuseaufbau anzugeben.

Diese Aufgabe wird erfindungsgemäß mit den im kennzeichnenden Teil des Anspruchs 1 angegebenen Maßnahmen gelöst.

Ausgestaltungen und Weiterbildungen der Erfindung sind in den Unteransprüchen angegeben.

Anhand der Zeichnung werden im folgenden die Erfindung sowie Ergänzungen und Weiterbildungen näher beschrieben und erläutert.

Es zeigen
die Figuren 1 und 2 ein erstes Ausführungsbeispiel und
die Figuren 3 und 4 ein zweites Ausführungsbeispiel der Erfindung, jeweils in einem Längsschnitt und einer Frontansicht.

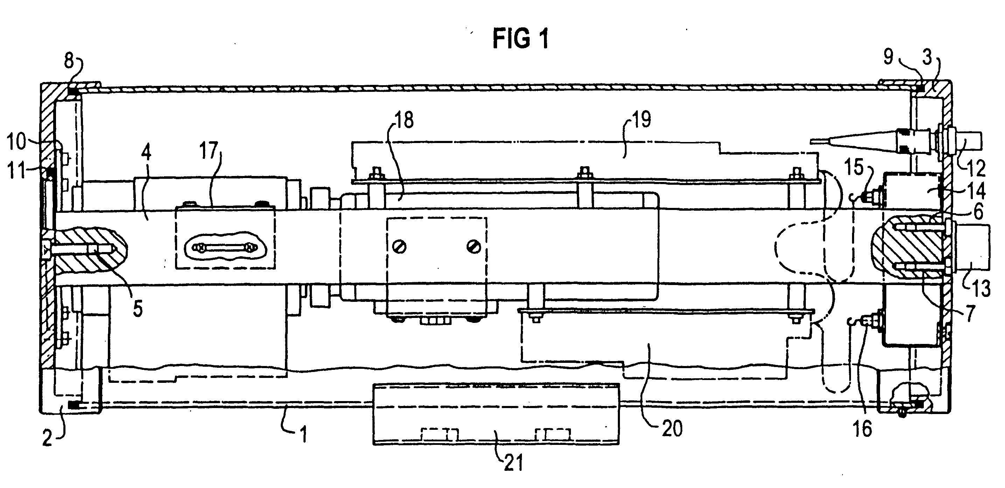

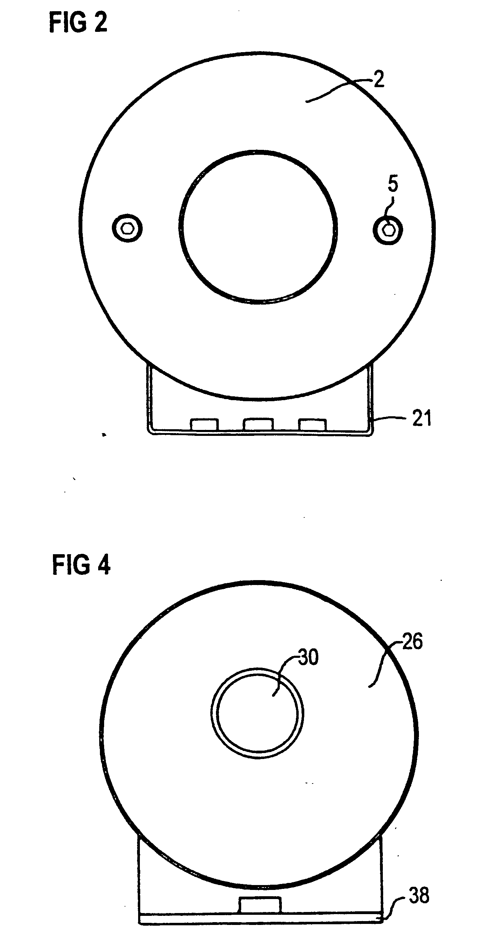

Die Figuren 1 und 2 zeigen in einem Schnitt und in einer Frontansicht das Gehäuse einer Kamera, wobei mit 1 ein metallischer Zylinder bezeichnet ist, dessen Stirnseiten von einer vorderen Metallkappe 2 und einer hinteren Metallkappe 3 verschlossen sind. Die beiden Metallkappen 2, 3 sind über zwei Träger, die parallel zur Kameraachse verlaufen und von denen in Figur 1 einer (4) den anderen verdeckt, miteinander verbunden. Mit Schrauben 5, 6, 7 werden über den Träger 4 und mit entsprechende Schrauben über den anderen Träger die Kappen 2, 3 gegeneinander gezogen und dadurch mit dem Zylinder 1 verspannt. Die Stirnränder des Zylinders 1 sitzen in Ringnuten der Kappen 2, 3, in die je eine Dichtung gegen elektromagnetische Strahlung, z. B. ein Metallgeflecht 8, 9, gelegt ist. Der Zylinder 1 wird daher in die Metallgeflechte 8, 9 gedrückt, so daß die Verbindungen zwischen den Kappen 2, 3 und dem Zylinder 1 gegen elektromagnetische Strahlung dicht sind. Anstelle eines Metallgeflechts kann auch ein anderes zur Abdichtung gegen elektromagnetische Strahlung geeignetes Material verwendet werden.

Die vordere Kappe 2 weist eine kreisförmige Öffnung auf, die nach innen gestuft und mit einer Glasscheibe verschlossen ist. Diese wird mit einem Ring 10 von innen gegen die Stufe gedrückt. Zur sicheren Abdichtung gegen elektromagnetische Strahlung ist auf die Glasscheibe von innen ein Abschirmnetz, hier ein Metallnetz, gespannt, wobei alternativ auch eine Beschichtung der Scheibe mit einem Metall vorgesehen sein kann. Zusätzlich ist um die Glasscheibe ein Ring 11 aus Metallgeflecht gelegt, gegen welches das über die Glasscheibe hinausragende Metallnetz gedrückt wird, so daß über den ganzen Umfang der Öffnung zwischen dem Metallnetz und der vorderen Kappe 2 eine sichere elektrische Verbindung besteht. Die Scheibe, das Metallnetz und auch der Ring 10 können durch Verkleben vormontiert sein.

In die hintere Kappe 3 sind Durchführungen 12, 13 für Licht- und elektrische Leitungen gesetzt. Die Durchführungen 12, 13 münden kameraseitig in einen geschirmten Raum 14 und sind mit Filtern verbunden, welche in die elektrischen Leitungen geschaltet sind. Weitere Durchführungen 15, 16 stellen die elektrische Verbindung zwischen den Filtern im geschirmten Raum 14 und den elektrischen bzw. elektronischen Komponenten der Kamera her.

Die optischen und elektronischen Bauteile der Kamera sind auf dem Träger 4 und dem in Figur 1 von diesem verdeckten, spiegelsymmetrischen Träger montiert. Unmittelbar hinter der Scheibe der vorderen Kappe 2 ist ein Objektiv mit zwei Winkeln 17 auf die Träger 4 geschraubt. Daran schließt sich in axialer Richtung eine Baugruppe 18 an mit gegebenenfalls einer Zwischenoptik, einem Bildwandler, z. B. einem CCD-Sensor oder einer Aufnahmeröhre und dazugehörenden elektronischen Komponenten. Weitere elektronische Baugruppen 19, 20, die auf Leiterplatten montiert sind, sind über und unter dem Trägern 4 angebracht.

Auf der Unterseite des Zylinders 1 ist eine Halterung 21 angebracht, mit der die Kamera auf einen Sockel, Schwenkantrieb oder dergleichen montiert werden kann.

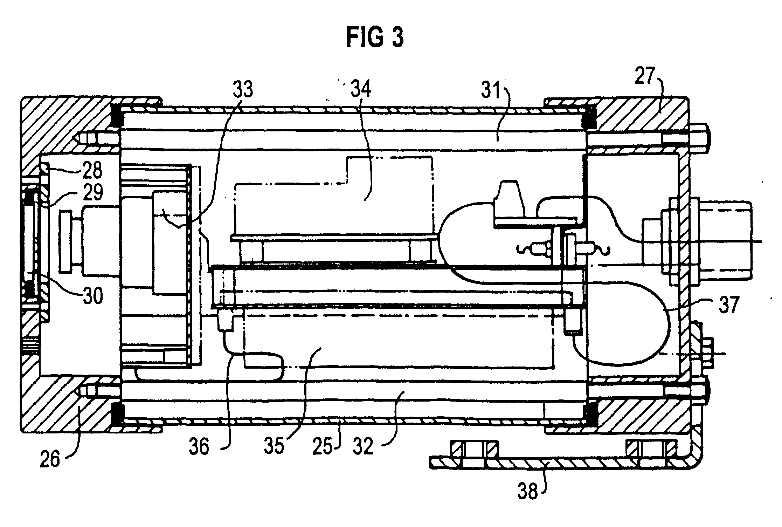

Die Figuren 3 und 4 zeigen in einem Schnitt und einer Frontansicht das Gehäuse einer Kamera, das wieder aus einem metallischen Zylinder 25, vorzugsweise aus Edelstahl, besteht, auf dessen Stirnseiten eine vordere und eine hintere Kappe 26 bzw. 27 sitzen. Die vordere Kappe 26 enthält wie die Kamera nach Figur 1 ein Fenster, das mit einer Scheibe 30 und einem dahinter angebrachten Metallnetz verschlossen ist. Mit einem Ring 28 werden die Scheibe 30 und das Metallnetz gehalten und außerdem das Metallnetz gegen einen Ring 29 aus Metallgeflecht gedrückt, so daß eine sichere Abschirmung auch im Bereich des Fensters erzielt ist. An der hinteren Kappe 27 sind Leitungsdurchführungen sowie in einem an die hintere Kappe 27 angrenzenden geschirmten Raum Filter angebracht, über welche die ein- und ausgehenden elektrischen Signale geführt sind.

Im Gegensatz zur Kamera nach Figur 1 ist der Zylinder 25 nicht mit zwei Trägern zwischen die Kappen 26, 27 eingespannt, sondern mittels zwei Schraubenbolzen 31, 32. Das Objektiv, der Bildwandler und weitere elektronische Bauelemente sind als komplette Einheit 33 an der vorderen Kappe 26 befestigt. Elektronische Baugruppen 34, 35 sitzen auf Platinen, die in den Zylinder 25 eingepaßt sind. Die elektrischen Verbindungen zwischen den an den beiden Kappen 26, 27 befestigten und den im Zylinder 25 sitzenden Baugruppen sind mit Leitungen 36, 37 hergestellt, die im zusammengebauten Zustand der Kamera Schleifen bilden.

An der hinteren Kappe 27 ist ein Winkel 38 befestigt, mit dem die Kamera auf einem Sockel, einem Schwenkantrieb oder dergleichen montiert werden kann.

## Patentansprüche

1. Gegen elektromagnetische Strahlung geschützte Videokamera mit einem zylindrischen Gehäuse, **dadurch gekennzeichnet**, daß das Gehäuse einen metallischen Zylinder (1; 25) aufweist, dessen Stirnseiten von metallischen Kappen (2, 3; 26, 27) verschlossen sind und daß die metallischen Kappen (2, 3; 26, 27) je eine Ringnut aufweisen, in die eine Dichtung gegen elektromagnetische Strahlung gelegt ist, auf dem die Stirnseite des metallischen Zylinders (1; 25) sitzt, und daß der metallische Zylinder (1) zwischen die beiden Kappen (2, 3) gespannt ist.

2. Videokamera nach Anspruch 1, **dadurch gekennzeichnet**, daß die vordere Kappe (2; 26) eine Öffnung aufweist, die mit einer durchsichtigen Scheibe (30) und mit einer Abschirmung für elektromagnetische Strahlung versehen ist, die mit der Kappe (2; 26) elektrisch verbunden ist, und daß hinter der Scheibe (30) das Kameraobjektiv angeordnet ist.

3. Videokamera nach Anspruch 2, **dadurch gekennzeichnet**, daß die Scheibe (30) mit einem Metall beschichtet ist.

4. Videokamera nach Anspruch 2, **dadurch gekennzeichnet**, daß die Scheibe (30) mit einem Abschirmnetz bedeckt ist.

5. Videokamera nach einem der Ansprüche 1 bis 4, **dadurch gekennzeichnet**, daß die hintere Kappe (3; 27) Durchführungen (12, 13) für elektrische oder optische Leiter enthält.

6. Videokamera nach einem der Ansprüche 1 bis 5, **dadurch gekennzeichnet**, daß die beiden Kappen (2, 3) mit zwei zur Kameraachse parallelen Trägern (4) verbunden sind, auf denen das Kameraobjektiv und elektronische Baugruppen (18, 19, 20) montiert sind.

7. Videokamera nach einem der Ansprüche 1 bis 6, **dadurch gekennzeichnet**, daß der Zylinder (1; 2) und die Kappen (2, 3; 26, 27) aus Edelstahl bestehen.

## Claims

1. Video camera protected against electromagnetic radiation, having a cylindrical housing, characterised in that the housing has a metallic cylinder (1; 25), the end faces of which are closed by metallic caps, (2, 3; 26, 27), and in that the metallic caps (2, 3; 26, 27) each have a ring groove into which a seal against electromagnetic radiation is placed, on which the end face of the metallic cylinder (1; 25) sits, and in that the metallic cylinder (1) is clamped between the two caps (2, 3).

2. Video camera according to claim 1, characterised in that the front cap (2; 26) has an opening which is provided with a transparent disc (30) and with a screen for electromagnetic radiation, which screen is electrically connected to the cap (2; 26), and in that the camera lens is arranged behind the disc (30).

3. Video camera according to claim 2, characterised in that the disc (30) is coated with a metal.

4. Video camera according to claim 2, characterised in that the disc (30) is covered with a screening net.

5. Video camera according to one of claims 1 to 4, characterised in that the rear cap (3; 27) contains lead-throughs (12, 13) for electrical or optical conductors.

6. Video camera according to one of claims 1 to 5, characterised in that the two caps (2, 3) are connected to two supports (4) which are parallel to the camera axis, on which supports the camera lens and electronic modules (18, 19, 20) are mounted.

7. Video camera according to one of claims 1 to 6, characterised in that the cylinder (1; 25) and the caps (2, 3; 26, 27) consist of high-grade steel.

## Revendications

1. Caméra vidéo protégée du rayonnement électromagnétique et comprenant un corps cylindrique, caractérisée en ce que le corps comporte un cylindre (1, 25) métallique dont les faces frontales sont fermées par des chapeaux (2, 3 ; 26, 27) métalliques, et, en ce que les chapeaux (2, 3 ; 26, 27) métalliques comportent respectivement une rainure annulaire dans laquelle est placée une garniture d'étanchéité vis-à-vis du rayonnement électromagnétique, sur laquelle viennent les faces frontales du cylindre (1, 25) métallique, et en ce que le cylindre (1) métallique est bloqué entre les deux chapeaux (2, 3).

2. Caméra vidéo suivant la revendication 1, caractérisée en ce que le chapeau (2, 26) avant comporte une ouverture, qui est munie d'une vitre (30) transparente et d'une protection vis-à-vis du rayonnement électromagnétique, qui est reliée électriquement au chapeau (2 ; 26), et en ce que l'objectif de la caméra est disposé derrière la vitre (30).

3. Caméra vidéo suivant la revendication 2, caractérisée en ce que la vitre (30) est revêtue d'un métal.

4. Caméra vidéo suivant la revendication 2, caractérisée en ce que la vitre (30) est revêtue d'un filet de protection.

5. Caméra vidéo suivant l'une des revendications 1 à 4, caractérisée en ce que le chapeau (3, 27) arrière comporte des traversées (12, 13) pour des lignes électriques ou optiques.

6. Caméra vidéo suivant l'une des revendications 1 à 5, caractérisée en ce que les deux chapeaux (2, 3) sont reliés par deux longerons (4) parallèles à l'axe de la caméra et sur lesquels sont montés l'objectif de la caméra et des modules (18, 19, 20) électroniques.

7. Caméra vidéo suivant l'une des revendications 1 à 6, caractérisée en ce que le cylindre (1, 25) et les chapeaux (2, 3 ; 26, 27) sont en acier fin.
